# EUROPÄISCHE PATENTSCHRIFT

(11) **EP 2 151 875 B1**
(45) Veröffentlichungstag und Bekanntmachung des Hinweises auf die Patenterteilung: **22.10.2014**
(21) Anmeldenummer: 09010220.3
(22) Anmeldetag: 07.08.2009
(51) Int. Cl.: H01L 41/053, H01L 41/23, H01L 41/047, B22D 19/04

(54) **Verfahren und Vorrichtung zur Herstellung eines Bauteils mit einem integrierten Einlegeteil**
Method and device for manufacturing a component with an integrated insert section
Procédé et dispositif de fabrication d'un composant doté d'une pièce d'insertion intégrée

(30) Priorität: 07.08.2008 DE 102008036741; 22.10.2008 DE 102008052653
(43) Veröffentlichungstag der Anmeldung: 10.02.2010
(73) Patentinhaber: Fraunhofer-Gesellschaft zur Förderung der angewandten Forschung e.V., 80686 München (DE); Universität Bremen, 28359 Bremen (DE)
(72) Erfinder: Pille, Christoph, 28195 Bremen (DE); Wöstman, Franz-Josef, 48163 Münster (DE); Pleteit, Hermann, 28215 Bremen (DE); Heuser, Michael, 28203 Bremen (DE)

(56) Entgegenhaltungen:
- WO-A1-91/03337
- DE-A1- 10 315 425
- JP-A- S5 568 168
- US-A1- 2005 133 187

## Beschreibung

Die Erfindung betrifft ein Verfahren und eine Vorrichtung zur Herstellung eines Bauteils mit einem integrierten Einlegeteil, insbesondere einer Funktionskeramik, welches zumindest ein elektrisches Anschlusselement umfasst, bei dem das Einlegeteil zumindest teilweise durch eine Isolierschicht umhüllt ist und bei dem das Einlegeteil zusammen mit der Isolierschicht in einer metallischen Matrix eingebettet ist.

Solche Bauteile mit integrierten Einlegeteilen werden beispielsweise als Sensoren oder Aktoren verwendet. Diese Einlegeteile umfassen bevorzugt eine Funktionskeramik, bzw. piezoelektrische Komponenten, die in verschiedensten technischen Bereichen eingesetzt werden. Dabei sollen zumeist Schwingungen in Bauteilen, Strukturen oder Baugruppen gedämpft werden. Eine solche aktive Dämpfung kann durch eine Schwingungsüberlagerung erfolgen. Solche erforderlichen Schwingungen können mit den Funktionskeramiken erzeugt werden, deren piezoelektrischer Effekt beim Anlegen einer elektrischen Spannung eine hochfrequente Verformung der Funktionskeramiken bewirkt. Die Anwendung wird als aktorische Anwendung bezeichnet. Die erzeugten Schwingungen können in einem solchen Fall von außen auf das Bauteil, die Struktur oder die Baugruppe übertragen oder durch eine bauteilintegrierte Funktionskeramik direkt in das Bauteil selbst eingeleitet werden. Ebenso ermöglichen solche Bauteile mit integrierten Einlegeteilen das Erfassen von Schwingungen oder Deformationen in Bauteilen, Strukturen oder Baugruppen. Diese Anwendung wird als sensorische Anwendung bezeichnet.

Darüber hinaus sind zum Beispiel aus einer Veröffentlichung "Praxis der Druckgussfertigung" von Ernst Brunhuber, Berlin, Verlag Schiehle & Schön, 1991, Seite 354 bis 367 Druckgusswerkzeuge bekannt, welche die Durchführung eines Druckgussverfahrens mit Einlegeteilen ermöglichen. Dabei werden Gewindestifte, Gewinde- und Lagerbuchsen, Stahlblechteile, Rohre oder dergleichen eingesetzt, um die Einlegeteile in dem Druckgusswerkzeug zu sichern. Diese Einlegeteile weisen darüber hinaus keine weitere Funktion auf bzw. müssen nach dem Gießvorgang gegebenenfalls wieder entfernt werden.

Aus der DE 102 11 107 A1 geht beispielsweise eine Funktionskeramik hervor, die insbesondere als Vielschicht-Stapelaktor ausgebildet ist. Dieser Vielschicht-Stapelaktor umfasst ein mehrteiliges metallisches Gehäuse, welches rohrförmig ausgebildet ist. Der aus Piezokeramik hergestellte Aktor wird auf ein Bodenteil geklebt. Anschließend wird ein rohrförmiger Gehäusemantel über den Aktor gesteckt. Schließlich wird ein Deckel ebenfalls mit dem Aktor verklebt. Dadurch wird eine abdichtende und geschlossene Anordnung sowie Kapselung des Aktors geschaffen. Diese Anordnung sowie der Aufbau ist sehr aufwändig. Insbesondere ist diese Anordnung für einen sehr kleinen Aufbau zur Integration in Bauteilen eher ungeeignet.

Aus der DE 103 15 067 A1 geht ein analoger Aufbau eines Aktors zum vorgenannten Vielschicht-Stapelaktor hervor. Dabei ist vorgesehen, dass ein zweiteiliges Gehäuse ineinander gesteckt wird, um darin den Aktor aufzunehmen. Anschließend wird durch das weitere Ineinanderstecken der Gehäusehälften der Aktor vorgespannt. Diese Anordnung wird dadurch aufrechterhalten, dass die beiden Gehäusehälften miteinander verschweißt werden. Eine solche Anordnung erfordert ein erhebliches Bauvolumen und kann nicht oder nur bedingt mit hohem Aufwand in ein Bauteil integriert werden.

Aus der DE 103 15 425 A1 geht ein Verfahren zur Herstellung eines Bauelementes mit einer Funktionskeramik hervor. Die Funktionskeramik umfasst zumindest ein elektrisches Anschlusselement, welches mit der Funktionskeramik verbunden ist, bevor eine elektrisch isolierende Umhüllung eingebracht wird. Anschließend wird die piezoelektrische Komponente sowie die elektrisch isolierende Umhüllung gemeinsam in eine metallische Matrix eingebettet bzw. von einer metallischen Matrix umgossen. Dabei ist vorgesehen, dass die metallische Matrix sowohl als ein Gehäuse ausgebildet sein kann, welches die piezoelektrische Komponente umgibt, so dass dieses Bauteil beispielsweise durch Anschrauben, Anschweißen oder Anlöten an ein weiteres Bauelement als Aktor eingesetzt werden kann. Des Weiteren kann die metallische Matrix derart ausgebildet sein, dass diese selbst als Bauelement ausgebildet ist, in dem die piezoelektrische Komponente eingebettet ist. Dadurch kann der Aktor in dem Bauelement selbst integriert sein. Dieses Bauelement ist in seiner Herstellung nur bedingt realisierbar. Insbesondere bei einem Einsatz von Druckgussverfahren kann die lagerichtige Anordnung der piezoelektrischen Komponente zur metallischen Matrix nicht reproduzierbar hergestellt werden.

Aus der DE 10 2005 018 936 A1 geht ein Gussbauteil mit einem integrierten Einlegeteil, insbesondere einer Funktionskeramik hervor. Die Funktionskeramik wird vor dem Einbringen in das Gussteil mit einer thermisch isolierenden Umhüllung versehen. Anschließend wird das zumindest teilweise umhüllte Einlegeteil in der Kavität einer Gussform positioniert und anschließend mittels eines Gussverfahrens mit einem Metall umschlossen. Dabei soll das Einlegeteil in der Gussform derart positioniert werden, dass die Strömungsgeschwindigkeit der zu vergießenden Metallschmelze im Bereich des Einlegeteiles niedrig ist. Dieses Bauteil mit einem integrierten Einlegeteil weist ebenfalls den Nachteil auf, dass trotz der Ausrichtung und Positionierung des Einlegeteils in der Gussform zur Erzielung einer niedrigen Strömungsgeschwindigkeit eine reproduzierbare und definierte Anordnung des Einlegeteils im Bauteil nicht gewährleistet ist.

Aus der DE 10 2005 016 402 A1 geht ein Verfahren zur Herstellung eines Gussbauteils hervor, in dem ein Einlegeteil integriert ist. Zur Einbindung von insbesondere empfindlichen und leicht zerbrechlichen Einlegeteilen in ein durch ein Gießverfahren hergestelltes Bauteil wird vorgeschlagen, dass auf das dünnwandige und zerbrechliche Einlegeteil eine Ummantelung aus einem Streckmetall oder Metallgewebe aufgebracht wird. Dieses Streckmetall oder Metallgewebe bildet eine permeable Membran, die von der flüssigen Metallschmelze infiltriert wird und die beim Eingießen der Schmelze entstehenden gießtechnisch bedingten hohen Kräfte zur Herstellung des Bauteils dämpfen sollen. Weiterhin soll durch die durchlässige Ummantelung eine formschlüssige Einbindung des Einlegeteils in das Bauteil gewährleistet sein. Die elektrische Kontaktierung der Funktionskeramik bzw. der piezoelektrischen Komponente in der metallischen Matrix erfolgt durch herkömmliche Drähte, die zuvor mit einer Polyamidfolie ummantelt wurden und undefiniert im Gießwerkzeug umgossen werden. Dieses Verfahren zur Herstellung eines Bauteils mit einem integrierten Einlegeteil weist den Nachteil auf, dass aufgrund der auftretenden extremen Strömungsgeschwindigkeiten die Ummantelungen die Funktionskeramik nicht vollständig abdecken und reproduzierbar in der Gussform fixieren können. Dadurch können Beschädigungen an der Funktionskeramik auftreten.

Der Erfindung liegt deshalb die Aufgabe zugrunde, ein Verfahren zur Herstellung eines Bauteils mit einem integrierten Einlegeteil, insbesondere einer Funktionskeramik sowie ein Bauteil mit einem integrierten Einlegeteil, insbesondere Funktionskeramik, vorzuschlagen, welches den Anforderungen bei der Herstellung eines solchen Bauteils gerecht wird, eine sichere Positionierung des Einlegeteils zum Bauteil während dessen Herstellung sowie eine reproduzierbare Herstellung eines solchen Bauteils zu ermöglichen.

Diese Aufgabe wird erfindungsgemäß durch ein Verfahren gemäß den Merkmalen des Anspruchs 1 gelöst. Bei diesem erfindungsgemäßen Verfahren ist vorgesehen, dass zumindest vor dem Einbetten des Einlegeteiles in der metallischen Matrix zumindest ein Positionierelement an dem Einlegeteil befestigt wird und dass das Einlegeteil während der Einbettung in die metallische Matrix durch das zumindest eine Positionierelement in einer ortsfesten Lage zur Gießform gehalten wird und dass das zumindest eine Positionierelement als weiteres Funktionselement des Einlegeteils ausgebildet wird. Durch das Anbringen des Positionierelementes an dem Einlegeteil vor dem Aufbringen der metallischen Matrix wird eine direkte Aufnahme des Einlegeteiles über das Positionierelement ermöglicht, welches eine definierte Zuordnung des Einlegeteiles in der Gießform vor einem anschließenden Einbetten in der metallischen Matrix ermöglicht. Da das Positionierelement für die metallische Matrix undurchlässig ist, kann ein Eindringen der metallischen Matrix zwischen dem Positionierelement und dem Einlegeteil und somit ein Ablösen verhindert werden. Dadurch wird die Reproduzierbarkeit in der definierten Lage des Einlegeteiles zum Bauteil hergestellt. Gleichzeitig kann durch die Fixierung des Einlegeteils in der Gießform eine Schädigung oder Verschiebung in der Lage des Einlegeteils durch die hohen Gießgeschwindigkeiten und insbesondere hohen Nachdrücke bzw. Metallverdichtung beim Druckgussverfahren verhindert werden. Gleichzeitig können die weiteren technischen Funktionen, wie beispielsweise die elektrische Kontaktierung des Einlegeteiles, ohne Beschädigungen aus dem Bauteil herausgeführt werden.

Nach einer vorteilhaften Ausgestaltung des Verfahrens ist vorgesehen, dass das zumindest eine Positionierelement als elektrisches Anschlusselement aus einem elektrisch leitenden Material ausgebildet wird und dass das zumindest eine Positionierelement, vorzugsweise vor der zumindest teilweisen Umhüllung durch eine Isolierschicht, unmittelbar mit dem Einlegeteil elektrisch leitend kontaktiert wird. Dadurch wird ermöglicht, dass durch die Isolierschicht der elektrisch leitfähige Kontakt zwischen dem Positionierelement und dem Einlegeelement geschützt wird, wobei bevorzugt ein elektrischer und/oder thermischer und/oder mechanischer Schutz durch die Isolierschicht gebildet wird.

Nach einer weiteren bevorzugten Ausgestaltung des Verfahrens ist vorgesehen, dass das Positionierelement durch ein leitfähiges Klebemittel, ein nicht leitfähiges Klebemittel mit einem dazwischenliegenden leitfähigen Kontakt, eine Lötverbindung, eine mechanische, form- oder kraftschlüssige Anordnung zum Einlegeteil elektrisch leitend kontaktiert wird. Als erste Alternative wird ein elektrisch leitfähiger Klebstoff vorgeschlagen, der sowohl die Fügeverbindung als auch die elektrische Anbindung herstellt. Eine weitere Alternative sieht vor, dass durch nicht leitfähige Klebstoffe entweder eine gute Haftung auf der Elektrode des Einlegeteils oder auf dessen elektrodenfreien Flächen hergestellt wird. Die elektrische Verbindung wird anschließend zwischen dem Einlegeteil und dem Positionierelement nur punktuell durch Lot oder elektrisch leitfähigen Klebstoff hergestellt. Eine weitere Alternative sieht die Ausgestaltung einer Lötverbindung zwischen dem Positionierelement und dem Einlegeteil vor. Darüber hinaus kann durch eine mechanische, form- oder kraftschlüssige Anordnung des Einlegeteiles mit dem Positionierelement eine elektrische Verbindung geschaffen werden.

Nach einer weiteren vorteilhaften Ausgestaltung des Verfahrens ist vorgesehen, dass das Einlegeteil mit zumindest einem daran angeordneten Positionierelement mit einer Isolierschicht zumindest teilweise umhüllt wird. Gemäß einer beispielhaften Ausführungsform können die Stirnflächen des Einlegeteils und die Kontaktflächen bzw. Anschlussabschnitte des Positionierelementes, die entfernt vom Einlegeteil liegen, ausgespart bzw. nicht umhüllt werden. Ebenso kann auch eine vollständige Umhüllung des Einlegeteils vorgesehen sein. Bevorzugt wird die Isolierschicht durch einen Gießprozess in einer Gießform vorgesehen, wobei die partielle Schichtdicke der Isolierschicht an die Bauteilgeometrie des Bauteils bzw. der aufzubringenden metallischen Matrix angepasst wird. Die Stirnflächen des Einlegeteiles werden dabei nicht mit Isolationsmaterial umhüllt, damit sie direkten Kontakt zur metallischen Matrix bekommen können. Die Aussparung der Anschlussabschnitte dient zur einfachen Kontaktierung des Einlegeteiles mit weiteren Anschlusselementen zur Ansteuerung des Einlegeteiles bzw. zur Übertragung von Informationen an eine Steuer- und/oder Auswerteeinrichtung.

Nach einer weiteren vorteilhaften Ausgestaltung des Verfahrens ist vorgesehen, dass auf die zumindest eine freie Kontaktfläche bzw. Anschlussabschnitte des Positionierelementes ein Hilfspositionierelement einer Gießform aufgesetzt wird, bevor das Einlegeteil in der Gießform positioniert wird. Dieses Hilfspositionierelement weist den Vorteil auf, dass die Positionierelemente bzw. die Anschlussabschnitte der elektrischen Anschlusselemente während dem Einbringen der metallischen Matrix geschützt bleiben. Gleichzeitig wird dadurch eine definierte und lagerichtige Positionierung des Einlegeteiles zum Hilfspositionierelement gewährleistet, welches wiederum bevorzugt durch eine konisch ovale Außenmantelfläche eine definierte Lage in der Gießform einnimmt. Alternativ kann vorgesehen sein, dass die Anschlussabschnitte der Positionierelemente, die aus der Isolierschicht herausragen, unmittelbar in Aufnahmen in der Gießform eingesetzt werden. Dadurch ist ebenfalls eine lagerichtige und reproduzierbare Anordnung des Einlegeteiles zur metallischen Matrix gegeben. Somit weist bei dieser ersten Ausführungsform das Positionierelement eine Doppelfunktion dahingehend auf, dass das zumindest eine Positionierelement zum einen zur lagerichtigen Positionierung des Einlegeteils im Gießwerkzeug dient und zum anderen als elektrisches Anschlusselement dient.

Nach einer alternativen vorteilhaften Ausgestaltung des Verfahrens ist vorgesehen, dass zumindest ein Positionierelement als Verbindungselement ausgebildet wird und an zumindest einer Stirnseite des Einlegeteils positioniert wird, bevor das Einlegeteil mit der Isolierschicht zumindest teilweise umhüllt wird. Dadurch wird ermöglicht, dass das Positionierelement ebenfalls zumindest teilweise von der Isolierschicht umgeben ist bzw. dass eine Mantelfläche des Positionierelementes an der Isolierschicht anliegt. Alternativ kann vorgesehen sein, dass das Positionierelement an der Stirnfläche des Einlegeteiles positioniert wird, bevor das Einlegeteil mit der bereits teilweise das Einlegeteil umhüllenden Isolierschicht zusammen mit dem zumindest einen Positionierelement in die Gießform, insbesondere zur Einstellung der lokalen Federkonstante der metallischen Matrix, eingelegt wird. Diese Anordnung weist den Vorteil auf, dass durch das Verbindungselement das Einlegeteil wiederum in der Gießform in einer definierten Lage positioniert gehalten ist, wobei nach dem Einbringen der metallischen Matrix eine Verbindung zwischen dem Positionierelement und dem Einlegeteil gegeben ist. Beispielsweise kann das Positionierelement bzw. Verbindungselement mechanische Anschlüsse oder Befestigungselemente umfassen, so dass das Bauteil an einem zu überwachenden oder aktiv zu beeinflussenden Bauelement befestigbar ist.

Nach einer weiteren vorteilhaften Ausgestaltung des Verfahrens ist vorgesehen, dass die Anschlusselemente getrennt von zumindest einem Positionierelement durch ein Einlegeteil elektrisch kontaktiert werden. Dadurch kann eine Entkopplung zwischen dem elektrischen Anschlusselement und dem Positionierelement in seiner Funktion als Verbindungselement ermöglicht sein. Diese elektrische Kontaktierung wird bevorzugt vor dem Umhüllen des Einlegeteiles mit einer Isolierschicht angebracht.

Des Weiteren ist bevorzugt vorgesehen, dass das zumindest eine Positionierelement unmittelbar an der Stirnfläche des Einlegeteiles zur flächigen Anlage positioniert und in dieser Lage in der Gussform gehalten wird. Dies weist den Vorteil auf, dass bei der Schwingungsübertragung oder Schwingungserkennung ein unmittelbarer metallischer Kontakt zwischen dem Verbindungselement und dem Einlegeteil bzw. der Funktionskeramik ohne eine Dämpfungswirkung ausgebildet wird.

Nach einer weiteren vorteilhaften Ausgestaltung des Verfahrens ist vorgesehen, dass das zumindest eine Positionierelement durch die zumindest teilweise das Einlegeteil umhüllende Isolierschicht ausgebildet wird. Diese Ausgestaltung ermöglicht ebenfalls die Vereinfachung des Herstellungsprozesses, da die Isolierschicht zur Trennung der metallischen Matrix zum Einlegeteil ohnehin erforderlich ist.

Bevorzugt ist vorgesehen, dass die Isolierschicht durch eine Materialanhäufung als Positionierelement ausgebildet wird, durch welche in der Gießform zum Einbringen der metallischen Matrix das Einlegeteil positioniert wird. Dabei werden insbesondere Bereiche zur Anordnung der Materialanhäufung vorgesehen, welche die Ausgestaltung der metallischen Matrix nicht beeinträchtigen oder bei einer Umschließung der metallischen Matrix keine Funktionsnachteile für das Einlegeteil mit sich bringen.

Nach einer weiteren bevorzugten Ausgestaltung des Verfahrens ist vorgesehen, dass die Anschlusselemente des Einlegeteiles mit dem Einlegeteil oder der zumindest teilweisen Umhüllung mit der Isolierschicht elektrisch kontaktiert werden und dass die Materialanhäufung zur Bildung des Positionierelementes zumindest in den Bereichen der Anschlusselemente vorgesehen wird, in denen die Anschlusselemente aus der Gießform herausgeführt werden. Durch diese Anordnung der Materialanhäufung in der Gießform kann des Weiteren sichergestellt werden, dass die Position der Anschlusselemente während dem Einbringen der metallischen Matrix gesichert ist und gleichzeitig auch die elektrische Anschlusskontaktierung zum Einlegeteil während eines Einbettungsvorganges nicht beschädigt wird.

Nach einer weiteren vorteilhaften Ausgestaltung des Verfahrens ist vorgesehen, dass die Isolierschicht aus Polymeren, insbesondere aus PEEK, PAI, PI, LCP, PSU, aus Dentalkunststoffen, aus Silikonen, aus Metalloxiden, aus Email, aus Glas, aus Keramik, aus Fasern oder Verbunde aus den vorgenannten Materialien hergestellt wird.

Nach einer weiteren vorteilhaften Ausgestaltung des Verfahrens ist vorgesehen, dass eine weitere Schicht auf die Isolierschicht aufgebracht wird, die zumindest zeitweise für die Dauer des Gießverfahrens temperaturbeständig ist. Dadurch kann während dem Eingießen der metallischen Matrix ein hoher Temperaturabbau ermöglicht sein, so dass das Einlegeteil nur mit einer verringerten Temperatur belastet wird. Diese weitere Schicht ist als sogenannte Opferschicht vorgesehen, um ein zumindest zeitweises Hitzeschild auszubilden.

Nach einer weiteren vorteilhaften Ausgestaltung des Verfahrens ist vorgesehen, dass das Einlegeteil durch ein schmelzmetallurgisches oder ein pulvermetallurgisches Verfahren insbesondere durch ein Gießverfahren aus einer metallischen Schmelze hergestellt wird.

Besonders bevorzugt ist ein Druckgussverfahren vorgesehen, bei welchem gleichzeitig mit dem Einbringen der metallischen Matrix ermöglicht ist, dass auf das Einlegeteil aufgrund der Schrumpfung der erstarrenden Metallschmelze während des Gießprozesses eine Vorspannung auf das Einlegeteil aufgebracht wird. Dies ist insbesondere bei der Ausgestaltung des Einlegeteils als Aktor vorgesehen. Bei einer sensorischen Anwendung des Einlegeteiles ist eine solche Vorspannung nicht zwingend erforderlich. Alternativ können weitere Gießverfahren, wie beispielsweise ein Schwerkraftguss (Sandguss), Kokillenguss, Lost-Foam-Guss, ein Thixo-Guss, ein Squeeze-Casting, ein Schleuderguss, vorgesehen sein. Ebenso können Verfahren mit Dauerform oder verlorener Form angewendet werden.

Nach einer weiteren bevorzugten Ausgestaltung ist vorgesehen, dass auf das Einlegeteil durch Nachdrücken im Gießprozess eine Vorspannung auf das Einlegeteil aufgebracht und eingestellt wird. Durch das gezielte Nachdrücken bzw. der gezielten Materialverdichtung kann die auf das Einlegeteil wirkende Vorspannung definiert eingestellt werden und ist nicht ausschließlich abhängig von der Schrumpfung des Materials.

Eine weitere vorteilhafte Ausgestaltung des Verfahrens sieht vor, dass während dem Eindringen der metallischen Matrix im Gießprozess die Anschlussabschnitte der Positionierelemente bzw. Trägerelemente elektrisch kurzgeschlossen werden. Dadurch wird ermöglicht, dass während der Formfüllung und anschließenden Erstarrung der metallischen Matrix die Einlegeteile, insbesondere die elektronische Funktionskeramik, nicht beschädigt wird. Aufgrund der Vorspannung auf das Einlegeteil werden insbesondere in elektronischen Funktionskeramiken elektrische Ladungen erzeugt, die durch die elektrische Kontaktierung abfließen können, ohne die Funktionskeramik zu zerstören.

Die erfindungsgemäße Aufgabe wird des Weiteren durch ein Bauteil mit einem integrierten Einlegeteil, insbesondere einer Funktionskeramik, gelöst, welches eine das Einlegeteil zumindest teilweise umhüllende metallische Matrix, in der das Einlegeteil eingebettet ist, aufweist, wobei zumindest ein mit dem Einlegeteil in Verbindung stehendes Positionierelement vorgesehen ist, das als weiteres Funktionselement ausgebildet ist, welches während dem Einbringen der metallischen Matrix in die Gießform das Einlegeteil in der Gießform lagerichtig fixiert und welches nach dem Einbetten des Einlegeteiles in die metallische Matrix in einer Außenumfangsfläche der metallischen Matrix positioniert ist oder aus der metallischen Matrix herausgeführt ist. Dieses erfindungsgemäße Bauteil ist bevorzugt durch ein Verfahren nach einem der vorbeschriebenen Ausführungsformen hergestellt.

Das erfindungsgemäße Bauteil weist den Vorteil auf, dass durch die Ausgestaltung des Positionierelementes als Funktionselement zwei Funktionen in einem Bauteil vereint werden können. Dies führt dazu, dass eine Reduzierung der Baukomponenten zur Herstellung des erfindungsgemäßen Bauteils ermöglicht ist. Gleichzeitig kann durch das Einbringen eines Positionierelementes bzw. eine Zuordnung des Positionierelementes zum Einlegeteil sichergestellt werden, dass während der Herstellung der metallischen Matrix in einer Gießform eine lagerichtige Positionierung und somit eine reproduzierbare Herstellung des Bauteils ermöglicht ist.

Nach einer ersten Ausführungsform des erfindungsgemäßen Bauteils ist vorgesehen, dass das Positionierelement als ein elektrisch leitendes Anschlusselement ausgebildet ist, welches vorzugsweise zumindest mit einer verwindungssteifen Körperachse ausgebildet ist. Bei dieser Ausführungsform wird die Funktion Positionierung und elektrische Kontaktierung in einem Bauteil vereint. Dadurch kann sichergestellt werden, dass die elektrischen Anschlusselemente in einer definierten Position gehalten werden, indem diese gleichzeitig als Positionierelement ausgebildet und somit zumindest in einer Körperachse verwindungssteif ausgestaltet sind.

Bevorzugt ist vorgesehen, dass das als Trägerelement ausgebildete Positionierelement streifenförmig oder T-förmig in der Geometrie ausgebildet ist. Dies ermöglicht eine eigensteife und verwindungssteife Ausgestaltung des Anschlusselementes, welches zudem eine einfache Positionierung bzw. ein einfaches Einstecken in die Gießform zur lagerichtigen Positionierung ermöglicht. Durch die T-förmige Ausgestaltung des Trägerelementes wird mit einem Schenkel eine flächige Anlage, bevorzugt über die gesamte Länge des Einlegeteils, ermöglicht, wodurch zusätzlich eine mechanische Versteifung des Einlegeteiles gegeben ist.

Nach einer weiteren alternativen Ausgestaltung des erfindungsgemäßen Bauteils ist vorgesehen, dass das Positionierelement als Verbindungselement ausgebildet ist, welches zumindest ein Befestigungselement oder eine mechanische Anschlussstelle aufweist. Bei dieser Ausführungsform wird die Funktion des Positionierens in der Gießform und das mechanische Befestigen des Bauteils an einem zu überwachenden Bauteil kombiniert. Somit wird wiederum eine Bauteilereduzierung erzielt. Das Verbindungselement weist beispielsweise als Befestigungselement ein Außen- oder ein Innengewinde, eine Anschlussfläche oder eine Flanschfläche oder dergleichen auf, damit das Bauteil an dem zu überwachenden Bauteil befestigbar ist.

Eine weitere alternative Ausgestaltung des erfindungsgemäßen Bauteils sieht vor, dass das Positionierelement als eine Materialanhäufung der Isolierschicht ausgebildet ist, die vorzugsweise an die metallische Matrix angrenzt oder aus dieser herausragend angeordnet ist. Dadurch kann beispielsweise ein elektrisches Anschlusselement, insbesondere ein Kabel, von einer Materialanhäufung umgeben sein, so dass diese Materialanhäufung als Positionierelement zur lagerichtigen Anordnung des Einlegeteils in der Gießform eingesetzt wird. Dadurch wird die Funktion des Positionierens und des Schutzes zum Herausführen eines flexiblen Anschlusselementes miteinander vereint. Durch eine solche Materialanhäufung kann das Einlegeteil im Gießwerkzeug form- oder kraftschlüssig fixiert werden. Das Isolationsmaterial ist dabei bevorzugt temperaturbeständig und mechanisch stabil.

Nach einer weiteren bevorzugten Ausgestaltung des Bauteils ist vorgesehen, dass das Einlegeteil mit einem Sensor, insbesondere einem Temperatursensor, gekoppelt ist. Diese Ausgestaltung weist den Vorteil auf, dass beim Einsatz des Einlegeteiles, insbesondere als Funktionskeramik, eine Temperaturüberwachung ermöglicht ist. Dadurch kann eine Überwachung des thermischen Zustands der Funktionskeramik erfolgen, um Beschädigungen zu vermeiden. Weitere Sensoren zur Überwachung der Funktion des Einlegeteiles oder des Einsatzes des Bauteils können ebenso vorgesehen sein. Solche Sensoren können mit einer RFID-Technologie ausgebildet sein, um drahtlos Daten zu übertragen.

Das Einlegeteil, welches in das Bauteil integriert wird, ist bevorzugt als Aktor, Sensor, Datenübertragungseinrichtung oder drahtlose Energie-übertragungseinrichtung ausgebildet. In Abhängigkeit der jeweiligen Anwendungsfälle kann die Funktionskeramik bzw. das Einlegeteil ausgewählt werden. Somit kann ein Bauteil mit einem integrierten Einlegeteil sowohl für die Belastungsmessung als auch zur aktiven Beeinflussung ausgewählt und eingesetzt werden.

Die Erfindung sowie weitere vorteilhafte Ausführungsformen und Weiterbildungen derselben werden im Folgenden anhand der in den Zeichnungen dargestellten Beispiele näher beschrieben und erläutert. Die der Beschreibung und den Zeichnungen zu entnehmenden Merkmale können einzeln für sich oder zu mehreren in beliebiger Kombination erfindungsgemäß angewandt werden. Es zeigen:
- Figur 1: eine perspektivische Ansicht eines erfindungsgemäßen Bauteils mit einem integrierten Einlegeteil,
- Figur 2: eine schematische Seitenansicht im Vollschnitt des Bauteils gemäß Figur 1,
- Figur 3: eine weitere schematische Seitenansicht im Vollquerschnitt des Bauteils gemäß Figur 1,
- Figur 4: eine perspektivische Ansicht auf ein Einlegeteil vor der Umhüllung mit einer Isolierschicht,
- Figur 5a: eine Explosionsdarstellung, welche das Einbringen des Einlegeteiles mit einem einteiligen Hilfspositionierelement in eine Gießform darstellt,
- Figur 5b: eine teilweise Explosionsdarstellung, welche das Einbringen eines Einlegeteils mit einem zweiteiligen Hilfspositionierelement in eine Gießform darstellt,
- Figur 6: eine perspektivische Ansicht eines Einlegeteils zur Herstellung eines alternativen Bauteils zu Figur 1,
- Figur 7: eine perspektivische Ansicht des Einlegeteils gemäß Figur 6 mit einer Isolierschicht,
- Figur 8: eine perspektivische Ansicht eines alternativen Bauteils zu Figur 1, ausgehend von Figur 6,
- Figur 9: eine perspektivische Ansicht eines Einlegeteils zur Herstellung eines weiteren alternativen Bauteils zu Figur 1,
- Figur 10: eine perspektivische Ansicht eines Einlegeteils mit einer Isolierschicht gemäß Figur 9,
- Figur 11: eine perspektivische Ansicht des Einlegeteils gemäß Figur 10 in einer Gießformund
- Figur 12: eine perspektivische Ansicht einer weiteren alternativen Ausführungsform eines Bauteils zu Figur 1, ausgehend von Figur 9.

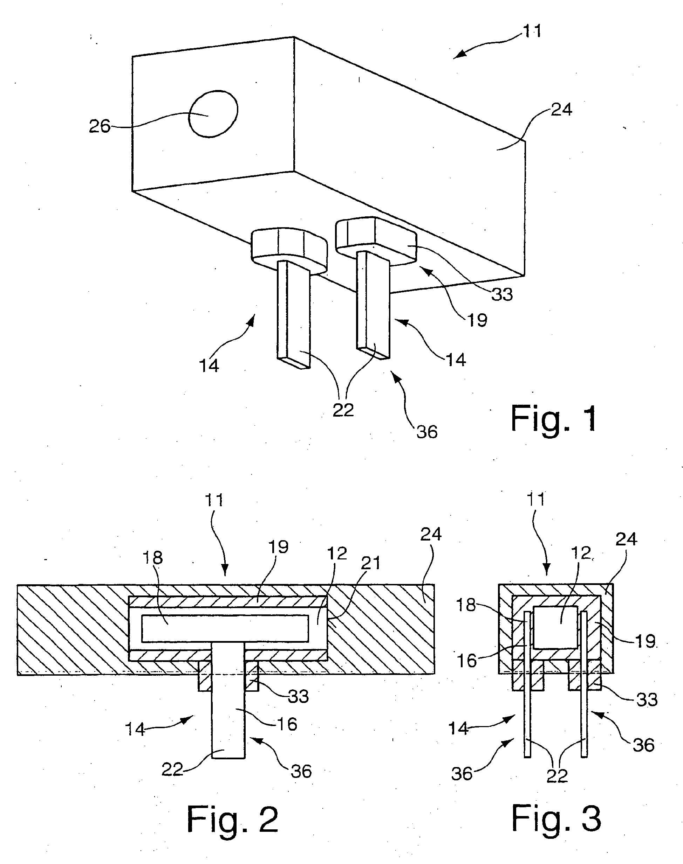

In Figur 1 ist eine erste Ausführungsform eines erfindungsgemäßen Bauteils 11 mit einem integrierten Einlegeteil 12 dargestellt, dessen Position im Bauteil 11 aus den Schnittdarstellungen gemäß Figur 2 und Figur 3 ersichtlich wird.

Das Einlegeteil 12 ist gemäß einer bevorzugten Ausführungsform als Funktionskeramik ausgebildet. Dabei ist vorgesehen, dass dieses Einlegeteil 12 beispielsweise als schichtweiser Aufbau von Stapelaktoren aus Keramik oder Elektrodenschichten aufgebaut ist. Das Einlegeteil 12 kann auch aus mehreren Komponenten bestehen und mit diesen gekoppelt werden. Beispielsweise kann die Funktionskeramik mit einem Sensor und weiteren Aktoren gekoppelt sein, ebenso mit Datenübertragungsmedien und dgl., um aufgrund der kombinierten Anwendung erhöhte Anforderungen zu erfüllen und flexible Einsatzmöglichkeiten zu eröffnen. Die Kombination mit einem Temperatursensor ermöglicht z.B. eine thermische Überwachung des Zustandes der integrierten Funktionskeramik, um diese vor Beschädigungen durch Hitze zu schützen. Auch ist eine mehrfache Anordnung von Funktionskeramiken und/oder weiteren Komponenten innerhalb der metallischen Matrix möglich. Bei mehreren Funktionskeramiken, die in X-, Y-, und Z- Richtung angeordnet sind, ist eine räumliche Überwachung oder ein räumliches Sehen im Bauteil ermöglicht. Alternativ können als Einlegeteil auch weitere elektronische Funktionselemente wie beispielsweise RFID-Transponder vorgesehen sein.

Zur Ansteuerung solcher Einlegeteile 12 ist erforderlich, dass eine elektrische Kontaktierung mit einem elektrischen Anschlusselement 36 erfolgt. Bei der ersten Ausführungsform erfolgt die elektrische Kontaktierung beispielsweise durch ein T-förmiges Trägerelement 16. Ein Schenkel des T-förmigen Trägerelementes 16 erstreckt sich vorzugsweise längs dem Einlegeteil 12, so dass die Elektroden des Einlegeteils 12 mit dem Trägerelement 16 verbindbar sind. An dem Einlegeteil 12 ist an zwei einander gegenüberliegende Seitenflächen jeweils ein Trägerelement 16 angeordnet, so dass die Schenkel 18 der Trägerelemente 16 rechtwinklig zum Einlegeteil 12 gesehen positioniert und beispielsweise parallel zueinander ausgerichtet sind. Die elektrische Kontaktierung erfolgt nach einer der vorstehend beschriebenen vier Arten.

Das zumindest eine elektrische Anschlusselement 36 ist bei dieser Ausführungsform als Positionierelement 14 zur Positionierung des Einlegeteils in einer Gießform 31 ausgebildet.

Das Positionierelement 14 ist bevorzugt aus einem vollflächigen Material ausgebildet, das für die Isolierschicht und die metallische Matrix undurchlässig ist. Alternativ kann auch vorgesehen sein, dass das Positionierelement für die Isolierschicht und/oder die metallische Matrix durchlässig ist und vorzugsweise das durchlässige Material eine Mindeststeifigkeit aufweist, um die Funktion als Positionierelement zu erfüllen.

Das Einlegeteil 12 sowie das elektrische Anschlusselement 36 werden bevorzugt von einer Isolierschicht 19 vollständig umhüllt, mit Ausnahme von Stirnflächen 21 des Einlegeteiles 12 und Kontaktabschnitten bzw. Anschlussabschnitten 22 der elektrischen Anschlusselemente 36. Durch die nicht umhüllende Ausgestaltung der Stirnfläche 21 ist ermöglicht, dass diese direkt mit einer metallischen Matrix 24 in Verbindung kommt, welche die Isolierschicht 19 und das Einlegeteil 12 umgibt. Die Isolierschicht 19 schützt das einzugießende Einlegeteil 12 während dem Gießprozess vor Beschädigungen durch thermische Belastungen des hohen Wärmeeintrages der Metallschmelze. Weiterhin schützt das Isolationsmaterial bzw. die Isolierschicht 19 das Einlegeteil 12 vor Beschädigungen speziell im Druckgussprozess durch die hohen Gießgeschwindigkeiten während der Formfüllphase sowie durch den Nachdruck während der Bauteilerstarrungsphase.

Die metallische Matrix kann aus Leichtmetall, insbesondere aus Aluminium, Magnesium, und deren Legierungen sowie aus Zink, Kupfer und Stahl und deren Legierungen bestehen.

Die metallische Matrix 24 umhüllt das Einlegeteil 12 sowie die Isolierschicht 19, wobei die freien Anschlussabschnitte 22 des elektrischen Anschlusselementes 36 nicht eingebettet werden. Beispielsweise kann, wie in Figur 1 dargestellt ist, an einer Stirnseite der metallischen Matrix ein Befestigungselement 26 vorgesehen sein, um das Bauteil 11 an einem weiteren zu überwachenden Bauteil 11 zu fixieren. Sofern die metallische Matrix 24 selbst das Bauteil 11 bildet, kann ein solcher Befestigungsabschnitt 26 entfallen.

Die metallische Matrix 24 selbst kann auch als ein elektrischer Kontakt genutzt werden, indem eine der Elektroden der Funktionskeramik mit der metallischen Matrix kontaktiert wird. Das Einlegeteil 12 benötigt in diesem Fall nur ein Positionierelement 14 oder ein elektrisches Anschlusselement 36.

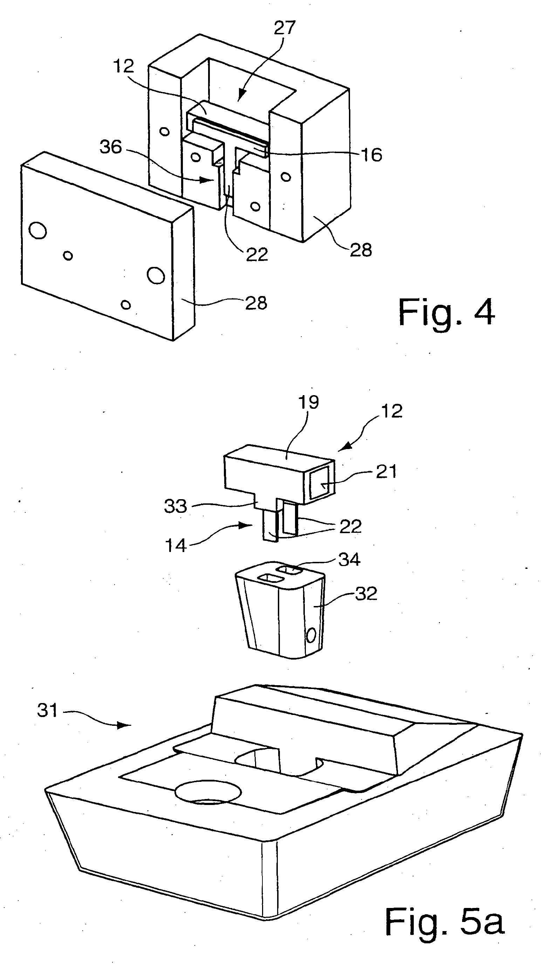

Die Herstellung des Bauteils 11 gemäß den Figuren 1 bis 3 nach dem Prinzip "Positionierung des Einlegeteils 12 über die Positionierelemente 14" erfolgt folgendermaßen: Zunächst werden die Trägerelemente 16 nach einer der vier vorbeschriebenen Arten zum Einlegeteil 12 elektrisch kontaktiert. Anschließend wird ein solches Zwischenprodukt 27 in eine erste Gießform 28 eingebracht, um beispielsweise in einem Gießprozess das Isoliermaterial einzubringen, um eine Isolierschicht 19 auszubilden, wie in Figur 4 dargestellt ist. Diese Gießform 28 ist derart ausgebildet, dass die Stirnflächen 21 des Einlegeteils 12 jeweils an einer Wandung der Gießform anliegen, so dass diese nicht von einem Isoliermaterial benetzt werden. Analoges gilt für die Anschlussabschnitte 22 der Trägerelemente 16. Diese Trägerelemente 16 bilden das Positionierelement 14.

Das Einlegeteil 12, welches mit einer Isolierschicht 19 gemäß dem Verfahrensschritt in Figur 4 versehen ist, wird nunmehr, wie in Figur 5a dargestellt, in die Gießform 31 positioniert, um das mit der Isolierschicht 19 versehene Einlegeteil 12 mit einer metallischen Matrix 24 zu versehen. Dabei ist gemäß einer ersten Ausführungsform vorgesehen, dass die Anschlussabschnitte 22 des Trägerelementes 16 in ein Hilfspositionierelement 32 eingesetzt werden. Bevorzugt ist vorgesehen, dass Isolierabschnitte 33 bündig in Öffnungen 34 des Hilfspositionierelementes 32 eingreifen, so dass eine definierte und lagerichtige Positionierung des Einlegeteils 12 zum Hilfspositionierelement 32 gegeben ist. Somit übernehmen die Trägerelemente 16 die Funktion als Positionierelement 14. Gleichzeitig wird dadurch sichergestellt, dass die metallische Matrix 24 nicht die Anschlussabschnitte 22 benetzt. Anschließend wird das Hilfspositionierelement 32 in die Gießform ebenfalls lagedefiniert eingesetzt.

Nachfolgend wird ein Oberteil der Gießform 31, das nicht näher dargestellt ist, aufgesetzt und die Gießform 31 geschlossen.

Während dem Einbringen der metallischen Matrix 24 werden die Anschlussabschnitte 22 des Positionierelementes 14 bzw. Trägerelementes 16 elektrisch kurzgeschlossen. Dies kann beispielsweise dadurch gewährleistet werden, indem ein elektrisch leitfähiges Hilfspositionierelement eingesetzt wird. Diese Kurzschließung ist erforderlich, da während der Formfüllung und anschließenden Erstarrung die Funktionskeramik gestaucht wird und dabei elektrische Ladungen entstehen. Können diese Ladungen nicht fließen, zerstören sie den piezoelektrischen Effekt der Funktionskeramik. Nach der Formfüll- und Erstarrungsphase muss das Bauteil 11 gekühlt werden, um die Dauer des Wärmeeintrags des heißen Metalls auf das Isoliermaterial und die Funktionskeramik zu reduzieren. Während des Gießprozesses wird gleichzeitig die Vorspannung auf die Funktionskeramik eingestellt. Durch die Erstarrung und Schrumpfung der Metallschmelze kontrahiert diese und staucht die Funktionskeramik, wodurch die Vorspannung erzeugt wird. Speziell im Druckgussverfahren wird das Bauteil durch den Kolbennachdruck während der Erstarrungsphase zusätzlich komprimiert, was den Vorspanneffekt verstärkt. Durch Variation des Kolbennachdrucks kann der Betrag der Vorspannung der Funktionskeramik eingestellt werden.

Nach dem Abkühlen des Bauteils 11 wird dieses aus der Gießform 31 entnommen.

Das Hilfspositionierelement 32 ist beispielsweise einteilig ausgebildet. Es kann alternativ auch zwei- oder mehrteilig ausgebildet sein. Alternativ kann anstelle der Verwendung eines Hilfspositionierelementes 32 vorgesehen sein, dass die Anschlussabschnitte 22 des Einlegeteils 12 unmittelbar bzw. direkt im Gießwerkzeug eingesteckt werden.

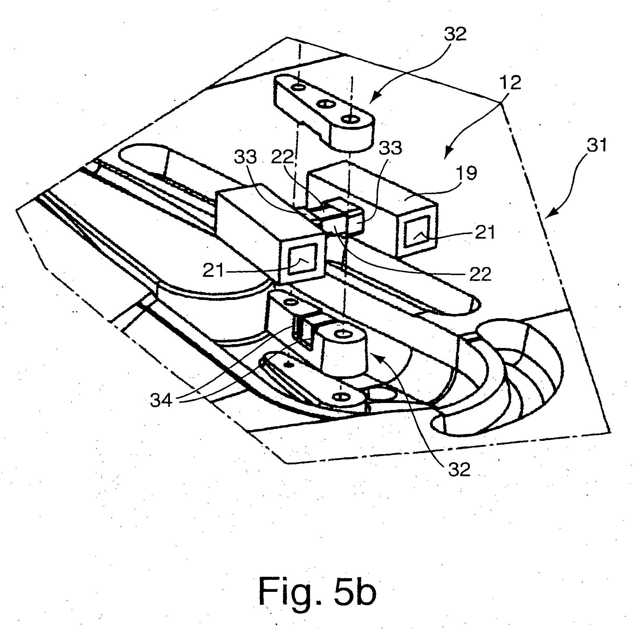

In Figur 5b ist eine Explosionsdarstellung einer alternativen Ausführungsform eines Einlegeteils 12 mit einer alternativen Ausführungsform eines Hilfspositionierelementes 32 in einer Gießform dargestellt. Das Einlegeteil 12 weicht von der in den Figuren 1 bis 4 dargestellten Ausführungsform dahingehend ab, dass zwei Einlegeteile 12 durch gemeinsame Anschlussabschnitte 22 miteinander verbunden sind, die gemeinsam in eine Gießform 28 eingelegt werden, um eine metallische Matrix 24 aufzubringen. Hierfür ist bspw. ein zweiteiliges Hilfspositionierelement 32 vorgesehen, welches an den Anschlussabschnitten 22 angreift und diese zu dem Hilfspositionierelement 32 fixiert. Das Hilfspositionierelement 32 kann wiederum in der Gießform eingesetzt und lagesicher fixiert werden. Diese Anordnung weist den Vorteil auf, dass auch in der Geometrie komplizierte Anschlussabschnitte 22 in einfacher Weise von Hilfspositionierelementen 32 aufgenommen werden können, so dass das Einlegeteil 12 oder die Einlegeteile 12 lagerichtig in der Gießform angeordnet werden. Die zweiteilig dargestellte Ausführungsform des Hilfspositionierelementes 32 ist nur beispielhaft, ebenso können drei- oder mehrteilige Hilfspositionierelemente 32 vorgesehen sein. Die Anordnung der Hilfspositionierelemente 32 kann durch eine Steck-, Rastverbindung als auch durch eine Stiftverbindung oder dergleichen ermöglicht werden, die für das Gießverfahren prozesssicher sind.

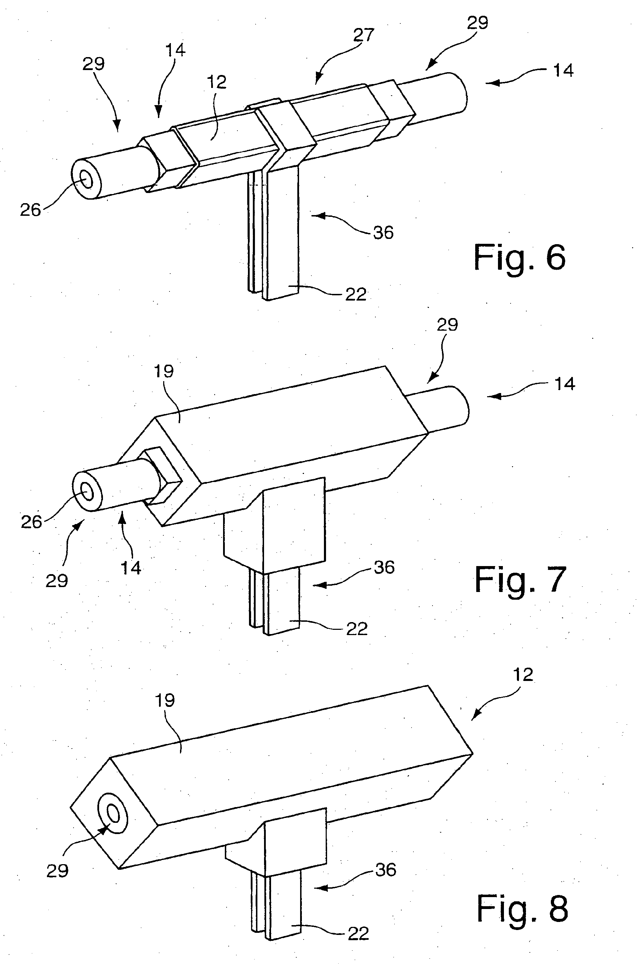

In Figur 6 ist eine perspektivische Ansicht des Einlegeteiles 12 dargestellt, welches für die Ausgestaltung einer alternativen Ausführungsform des Bauteils 11 vorbereitet wird. Diese Ausführungsform wird nach dem Prinzip "Positionierung des Einlegeteils 12 über Verbindungselemente 29" hergestellt. An den Stirnflächen 21 des Einlegeteils 12 sind jeweils Positionierelemente 14 angeordnet, die gleichzeitig die Funktion als Verbindungselement 29 aufweisen. Bei diesem Ausführungsbeispiel ist beispielsweise in dem Positionierelement 14 ein Befestigungselement 26 vorgesehen, das als Gewinde oder dergleichen ausgebildet sein kann. Zur elektrischen Kontaktierung des Einlegeteils 12 ist beispielsweise ein streifenförmiges elektrisches Anschlusselement 36 vorgesehen, welches das Einlegeteil 12 zumindest teilweise umgibt. Bevorzugt sind wiederum zwei parallel ausgerichtete Anschlussabschnitte 22 vorgesehen, welche eine elektrische Kontaktierung mit einer Auswerteeinheit und/oder Steuereinheit ermöglichen.

Die in Figur 6 dargestellte Anordnung wird in Analogie zum Zwischenprodukt 27 in eine Gießform 28 gemäß Figur 4 eingelegt, wobei die Geometrie der Gießform an die Positionierelemente 14 bzw. Verbindungselemente 29 angepasst ist. Nach dem Aufbringen einer Isolierschicht 19 kann ein weiteres Zwischenprodukt erhalten werden, welches beispielsweise in Figur 7 dargestellt ist. Dabei ist vorgesehen, dass die Isolierschicht 19 zumindest teilweise die elektrischen Anschlusselemente 36 umgibt, so dass Anschlussabschnitte 22 frei bleiben. Das Positionierelement 14 kann zumindest teilweise von der Isolierschicht 19 umgeben sein, wobei die Isolierschicht 19 unmittelbar an das Positionierelement 14 angrenzend oder mit der dieser sogar verbunden sein kann. Anschließend wird das in Figur 7 dargestellte, mit einer Isolierschicht 19 zumindest teilweise umgebene Einlegeteil 12 wiederum in eine Gießform 31 eingesetzt. Dabei ist vorgesehen, dass die Positionierelemente 14 zur lagerichtigen Fixierung in der Gießform dienen, so dass das Einlegeteil 12 sowohl in axialer Richtung der Positionierelemente 14 als auch in deren weiteren Raumrichtungen fixiert ist. Ergänzend kann vorgesehen sein, dass ein Hilfspositionierelement 32 auf die Anschlussabschnitte 22 aufgesteckt wird. Bei dieser Ausführungsform kann dieses Hilfspositionierelement 32 jedoch lediglich als Schutz dienen, damit eine metallische Matrix 24 diese Anschlussabschnitte 22 nicht benetzt.

Das als Verbindungselement 29 ausgebildete Positionierelement 14 ist bevorzugt aus Stahl oder aus hartem Werkstoff ausgebildet, so dass bei einer Krafteinleitung eine optimale Kraftweiterleitung auf das Einlegeteil 12 ermöglicht ist. Das Verbindungselement kann weitere Funktionen aufweisen und/oder übernehmen. Durch das Verbindungselement kann aufgrund der Materialauswahl, der Geometrie und/oder des Querschnittsprofils eine Steifigkeit oder lokale Federkonstante in der Isolierschicht 19 und/oder der metallischen Matrix 24, insbesondere an der Stirnfläche 21 des Einlegeteils 12, eingestellt werden. Das Verbindungselement 29 kann in der Isolierschicht 19 und/oder der metallischen Matrix 24 positioniert sein.

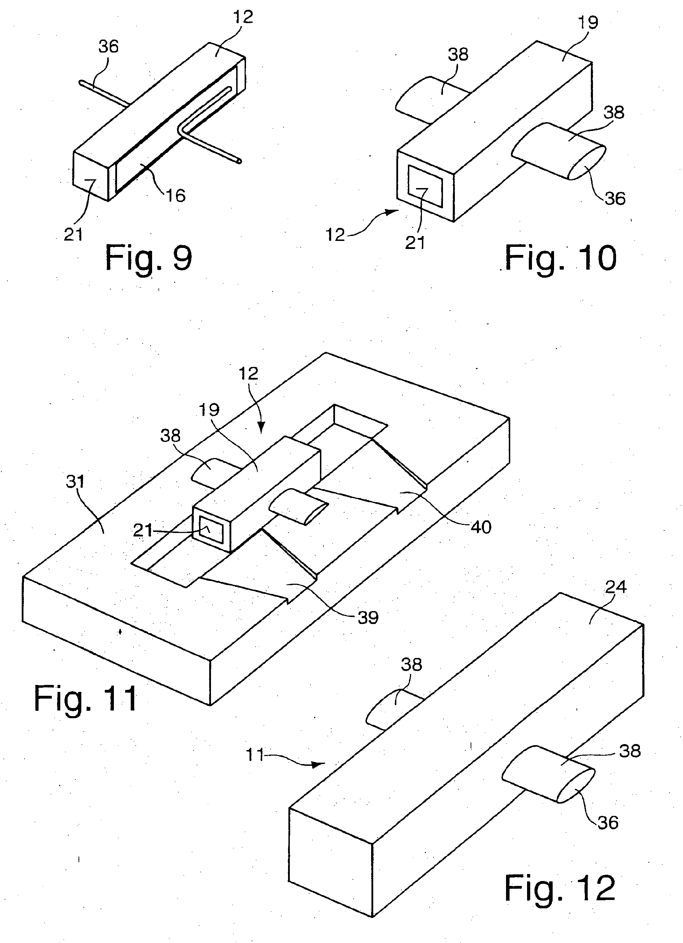

In Figur 9 ist ein Einlegeteil 12 perspektivisch dargestellt, welches zum Aufbau einer weiteren alternativen Ausführungsform des Bauteils 11 vorgesehen ist. Die Ausführungsform wird nach dem Prinzip "Positionierung des Einlegeteils 12 über Isolierelement 19" hergestellt. Beispielsweise ist entlang den Seitenflächen des Einlegeteils 12 ein streifenförmiges Trägerelement 16 angeordnet. Auf diesem Trägerelement 16 ist ein elektrisches Anschlusselement 36 direkt befestigt oder über eine nachfolgend zumindest teilweise aufgebrachtes Isolierelement, insbesondere eine Isolierschicht 19 zum Trägerelement 16 fixiert. Die Isolierschicht 19 ist wiederum derart vorgesehen, dass die Stirnflächen 21 des Einlegeteils 12 frei bleiben.

Bei dieser Ausführungsform ist das Positionierelement 14 durch eine Materialanhäufung 38 der Isolierschicht 19 ausgebildet, welche das elektrische Anschlusselement 36 umgibt. Dies ist in Figur 10 dargestellt. Diese Materialanhäufung 38 dient als Positionierelement 14 in der Gießform 31, wie dies in Figur 11 dargestellt ist. Somit können weitere mechanische Stütz- oder Fixierelemente entfallen. Gleichzeitig wird das elektrische Anschlusselement 36 lagefixiert und gesichert von dem Einlegeteil 12 aus der metallischen Matrix 24 herausgeführt.

Aus Figur 11 geht hervor, dass durch die beispielsweise im Querschnitt oval ausgebildete Materialanhäufung 38 das mit der Isolierschicht 19 umgebene Einlegeteil 12 lagefixiert aufgenommen werden kann. Dadurch ist weder ein Verdrehen des Einlegeteiles 12 noch ein Verschieben innerhalb der Kavität der Gießform 31 möglich.

Die metallische Matrix 24 wird über den Anguß 39 der Kavität zugeführt. Die Entlüftung kann z.B. über den Entleerungsanschluss 40 erfolgen. Nach dem Einbringen der metallischen Matrix 24 in die Gießform 31 kann ein Bauteil 11 aus der Gießform 31 entnommen werden, wie dies beispielsweise in Figur 12 dargestellt ist. Dabei ist bevorzugt vorgesehen, dass die Materialanhäufung 38 aus der Matrix 24 herausragt. Alternativ kann vorgesehen sein, dass die Materialanhäufung 38 bzw. deren Stirnfläche in einem Außenwandabschnitt der metallischen Matrix 24 liegt und lediglich der elektrische Leiter 36 weiter herausgeführt ist.

Aufgrund der vorbeschriebenen Ausführungsbeispiele und Verfahrensschritte zur Herstellung eines Bauteils 12 ergeben sich folgende Vorteile:
Die Einlegeteile 12 können direkt in ein metallisches Gehäuse integriert werden. Es ist eine direkte Integration der Einlegeteile 12 während der Bauteilentstehung im Gießverfahren, speziell im Druckgussverfahren, möglich. Die Einbettung des Einlegeteils 12 in die fließende Metallschmelze ermöglicht eine optimale Anbindung an die Funktionsflächen bzw. die Stirnflächen des Einlegeteiles 12 an die Materialstruktur des Metalls. Der gesamte Fertigungsprozess zur Herstellung ummantelter Einlegeteile 12 wird vereinfacht. Insbesondere auf die Herstellung von Gehäusekomponenten mit sehr hohen Fertigungstoleranzen kann verzichtet werden, die zum geometrisch exakten Einbau von Einlegeteilen 12 erforderlich wäre. Diese Fertigungstoleranzen werden überflüssig, da sich die flüssige Metallmatrix 24 der Position des Einlegeteils 12 im Bauteil 11 anpasst. Weiterhin wird die Anzahl der Fertigungsschritte im Vergleich zu aus dem Stand der Technik bekannten Fertigungsprozessen reduziert. Somit wird eine Kostensenkung bei der Herstellung erzielt. Durch die gießtechnische Integration des Einlegeteils 12 in das Bauteil 11 kann dieses geometrisch frei im späteren Bauteil 11 positioniert werden. Durch die Ausgestaltung der Positionierelemente 14 kann diese freie geometrische Anordnung sichergestellt werden. Ebenfalls kann die Geometrie des umgossenen Metallgehäuses geometrisch frei gewählt werden. Diese Möglichkeit besteht bei einer manuellen nachträglichen Integration in ein Metallbauteil vielfach nicht oder erfordert einen hohen Bearbeitungsaufwand. Das vorstehende Verfahren ermöglicht eine hohe Gestaltungsfreiheit zur Herstellung komplexer Gehäusegeometrien. Bei Anwendung eines mehrteiligen Positionierelementes 14 wird die Schließkraft des Schließwerkzeuges dazu genutzt, die einzelnen Komponenten des Positionierelementes 14 fest miteinander zu verschließen und somit die einzugießende Funktionskeramik für den Druckprozess mechanisch stabil zu fixieren.

Im Hinblick auf das erfindungsgemäße Bauteil 11, welches nach dem erfindungsgemäßen Verfahren hergestellt ist, ergeben sich folgende Vorteile: Das integrierte Einlegeteil 12 kann nach dem Einguss in die metallische Matrix 24 direkt kontaktiert werden. Das Einlegeteil 12 ist in der metallischen Matrix 24 bzw. in dem durch die metallische Matrix 24 gebildeten Gehäuse gegen äußere Einflüsse wie beispielsweise Gas, Flüssigkeit, Feuchtigkeit, Staub, Schmutz und dergleichen geschützt. Ebenfalls schützt die vollständige Einbindung des Einlegeteils 12 in der metallischen Matrix 24 vor mechanischen Beschädigungen und Manipulationen. Durch die Isolierschicht 19 wird das Einlegeteil 12 elektrisch von der metallischen Matrix 24 isoliert. Zusätzlich ermöglicht die Isolierschicht 19 eine Verformung des Einlegeteils 12 in der metallischen Matrix 24 bzw. dem Metallgehäuse in Querrichtung bei Längsverformung durch Druck-Zugbelastung, Schwingung oder aktiv aktorische Arbeit. Das eingegossene Einlegeteil 12 im Bauteil 11 ermöglicht sowohl aktiv aktorische Anwendungen, wie beispielsweise durch Schwingungs- und Vibrationsdämpfung, zur Positionierung und Justierung oder dergleichen als auch sensorische Anwendungen, wie beispielsweise die Messung von Druck- und Zugkräften, sowie Torsion, Schwingung, mechanische Verformung und Längenänderung und dergleichen.

## Patentansprüche

1. Verfahren zur Herstellung eines Bauteils (11) mit einem integrierten Einlegeteil (12), insbesondere einer Funktionskeramik, welches zumindest ein elektrisches Anschlusselement (36) umfasst,
- bei dem das Einlegeteil (12) in eine metallische Matrix (24) eingebettet wird,
**dadurch gekennzeichnet,**
- **dass** zumindest vor dem Einbetten des Einlegeteils (12) in der metallischen Matrix (24) zumindest ein Positionierelement (14) am Einlegeteil (12) befestigt wird,
- **dass** das Einlegeteil (12) während der Einbettung in die metallische Matrix (24) durch das zumindest eine Positionierelement (14) in einer ortsfesten Lage zur Gießform (31) gehalten wird und
- **dass** das zumindest eine Positionierelement (14) als weiteres Funktionselement (29, 36, 38) des Einlegeteils (12) ausgebildet wird.

2. Verfahren nach Anspruch 1, **dadurch gekennzeichnet, dass** das zumindest eine Positionierelement (14) als elektrisches Anschlusselement (36) aus einem elektrisch leitenden Material ausgebildet wird und dass das zumindest eine Positionierelement (14), vorzugsweise vor dem zumindest teilweisen Umhüllen des Einlegeteiles (12) durch eine Isolierschicht (19), unmittelbar mit dem Einlegeteil (12) elektrisch leitend kontaktiert wird.

3. Verfahren nach Anspruch 1 oder 2, **dadurch gekennzeichnet, dass** das Positionierelement (14) durch ein elektrisch leitfähiges Klebemittel, durch ein nicht elektrisch leitfähiges Klebemittel mit einem dazwischenliegenden leitfähigen Kontakt, durch eine Lötverbindung, durch eine metallische, form- oder kraftschlüssige Anordnung zum Einlegeteil (12) elektrisch leitend verbunden wird.

4. Verfahren nach einem der vorhergehenden Ansprüche, **dadurch gekennzeichnet, dass** das Einlegeteil (12) mit dem zumindest einen daran angeordneten Positionierelement (14) mit einer Isolierschicht (19) zumindest teilweise umhüllt wird, wobei vorzugsweise Stirnflächen (21) des Einlegeteils (12) und Anschlussabschnitte (22) des Positionierelementes (14) nicht umhüllt werden.

5. Verfahren nach einem der vorhergehenden Ansprüche, **dadurch gekennzeichnet, dass** auf den zumindest einen freien Anschlussabschnitt (22) des Positionierelements (14) ein Hilfspositionierelement (32) der Gießform (31) aufgesetzt wird, bevor das Einlegeteil (12) in die Gießform (31) positioniert wird oder dass der zumindest eine freie Anschlussabschnitt (22) des zumindest einen Positionierelementes (14) unmittelbar in die Gießform (31) eingesetzt wird.

6. Verfahren nach Anspruch 1, **dadurch gekennzeichnet, dass** das zumindest eine Positionierelement (14) als Verbindungselement (29) ausgebildet wird und an zumindest einer Stirnseite (21) des Einlegeteils (12) positioniert wird, bevor das Einlegeteil (12) mit der Isolierschicht (19) zumindest teilweise umhüllt wird oder das Einlegeteil (12) und das Positionierelement (14) in die Gießform (31), insbesondere zur Einstellung der lokalen Federkonstante der metallischen Matrix, eingelegt wird, und dass vorzugsweise das zumindest eine Positionierelement (14) unmittelbar an der Stirnfläche (21) des Einlegeteils (12) zur flächigen Anlage positioniert und in der Gießform (31) gehalten wird, und dass insbesondere die Anschlusselemente (36) getrennt von dem zumindest einen Positionierelement (14) an dem Einlegeteil (12) elektrisch leitend kontaktiert werden.

7. Verfahren nach Anspruch 1, **dadurch gekennzeichnet, dass** das zumindest eine Positionierelement (14) durch die zumindest teilweise das Einlegeteil (12) umhüllende Isolierschicht (19) vorzugsweise durch eine Materialanhäufung (38) der Isolierschicht (19), durch welche das Einlegeteil (12) in der Gießform (31) lagerichtig positioniert wird, ausgebildet wird, und insbesondere die Anschlusselemente (36) mit dem Einlegeteil (12) vor dem zumindest teilweisen Umhüllen mit der Isolierschicht (19) elektrisch kontaktiert werden und bevorzugt die Materialanhäufung (38) zur Bildung des zumindest einen Positionierelementes (14) zumindest in dem Bereich der Anschlusselemente (36) vorgesehen wird, der die Anschlusselemente (36) aus der metallischen Matrix (24) herausführt.

8. Verfahren nach einem der vorhergehenden Ansprüche, **dadurch gekennzeichnet, dass** die Isolierschicht (19) aus Polymeren, insbesondere aus PEEK, PAI, PI, LCP, PSU, aus Dentalkunststoffen, aus Silikon, aus Metalloxiden, aus Email, aus Glas, aus Keramik, aus Fasern oder Verbunde aus den vorgenannten Materialien hergestellt wird.

9. Verfahren nach einem der vorhergehenden Ansprüche, **dadurch gekennzeichnet, dass** eine weitere Schicht auf das Einlegeteil (12) oder die Isolierschicht (19) aufgebracht wird, die zumindest zeitweise für die Dauer des Gießverfahrens temperaturbeständig ist.

10. Verfahren nach einem der vorhergehenden Ansprüche, **dadurch gekennzeichnet, dass** das Einlegeteil (12) schmelzmetallurgisch oder pulvermetallurgisch, insbesondere durch ein Gussverfahren oder Druckgussverfahren, mit einer metallischen Schmelze eingebettet wird.

11. Verfahren nach einem der vorhergehenden Ansprüche, **dadurch gekennzeichnet, dass** auf das Einlegeteil (12) durch die metallische Matrix eine Vorspannung aufgebracht wird und vorzugsweise durch Nachdrücken während des Gießprozesses eine auf das Einlegeteil (12) wirkende Vorspannung eingestellt wird.

12. Verfahren nach einem der vorhergehenden Ansprüche, **dadurch gekennzeichnet, dass** während dem Einbringen der metallischen Matrix (24) die Anschlussabschnitte (22) der Positionierelemente (14) oder Trägerelemente (16) elektrisch kurzgeschlossen werden.

13. Bauteil mit einem integrierten Einlegeteil (12), insbesondere einer Funktionskeramik, welches insbesondere nach einem Verfahren gemäß den Ansprüchen 1 bis 12 hergestellt ist,
- mit einer metallischen Matrix (24), in der das Einlegeteil (12) eingebettet ist,
**dadurch gekennzeichnet,**
- **dass** zumindest ein mit dem Einlegetell (12) in Verbindung stehendes Positionierelement (14) vorgesehen ist, das als weiteres Funktionselement (29, 36, 38) ausgebildet ist und
- **dass** während dem Einbringen der metallischen Matrix (24) in die Gießform (31) das Einlegeteil (12) in der Gießform (31) lagerichtig durch das zumindest eine Positionierelement (14) fixiert ist, welches nach dem Einbetten des Einlegeteils (12) in die metallische Matrix (24) in einer Außenumfangsfläche der metallischen Matrix (24) positioniert ist oder aus der metallischen Matrix (24) herausgeführt ist.

14. Bauteil nach Anspruch 13, **dadurch gekennzeichnet, dass** das Positionierelement (14) als ein elektrisch leitendes Anschlusselement (36) ausgebildet ist, welches vorzugsweise durch ein Trägerelement (16) mit zumindest einer verwindungssteifen Körperachse ausgebildet ist.

15. Bauteil nach Anspruch 13, **dadurch gekennzeichnet, dass** das Trägerelement (16), welches vorzugsweise streifenförmig oder T-förmig ausgebildet ist, mit zumindest einem Endabschnitt an dem Einlegeteil (12) verbunden ist und gegenüberliegend ein freies Ende als Anschlussabschnitt (22) aufweist.

16. Bauteil nach Anspruch 13, **dadurch gekennzeichnet, dass** das Positionierelement (14) als Verbindungselement (29) ausgebildet ist und zumindest einen Befestigungsabschnitt (26) aufweist, und dass bevorzugt das Positionierelement (14) als eine Materialanhäufung (38) der Isolierschicht (19) ausgebildet ist und an die metallische Matrix (24) angrenzt oder gegenüber dieser herausragend angeordnet ist, und vorzugsweise ein elektrisches Anschlusselement (36) umgibt.

17. Bauteil nach einem der Ansprüche 13 bis 16, **dadurch gekennzeichnet, dass** das Einlegeteil (12) mit einem Sensor, insbesondere einem Temperatursensor, gekoppelt ist oder dass das Einlegeteil (12) als Aktor, Sensor, Datenübertragungseinrichtung oder drahtlose Energieübertragungseinrichtung ausgebildet ist.

## Claims

1. Process for the production of a component (11) with an integrated insertion part (12); in particular a functional ceramic, which comprises at least one electrical connection element (36),
• in which the insertion part (12) is embedded into a metal matrix (24), **characterised in that**
• at least one positioning element (14) is fastened to the insertion part (12) at least before the insertion part (12) is embedded in the metal matrix (24),
• that while being embedded into the metal matrix (24) the insertion part (12) is held in a fixed position relative to the mould (31) and
• that the at least one positioning element (14) is configured as a further function element (29, 36, 38) of the insertion part (12).

2. Process according to claim 1, **characterised in that** the at least one positioning element (14) is configured as an electrical connection element (36) made of an electrically conductive material, and that preferably before the insertion part (12) is at least partially encased by an insulating layer (19), the at least one positioning element (14) is connected directly with the insertion part (12) in an electrically conductive manner.

3. Process according to claim 1 or 2, **characterised in that** the positioning element (14) is connected to the insertion part (12) in an electrically conductive manner by an electrically conductive adhesive, by a non-electrically conductive adhesive with an interposed conductive contact, by a soldered joint, by a metal positive- or non- positive-locking arrangement.

4. Process according to one of the preceding claims, **characterised in that** the insertion part (12) with the at leat one positioning element (14) arranged thereon is encased at least partially with an insulating layer (19), wherein faces (21) of the insertion part (12) and connection sections (22) of the positioning element (14) are preferably not encased.

5. Process according to one of the preceding claims, **characterised in that** an auxiliary positioning element (32) of the mould (31) is placed onto the at least one free connection section (22) of the positioning element (14) before the insertion part (12) is placed into the mould (31), or that the at least one free connection section (22) of the at least one positioning element (14) is inserted directly into the mould (31).

6. Process according to claim 1, **characterised in that** the at least one positioning element (14) is configured as a connecting element (29) and is positioned on at least one face (21) of the insertion part (12) before the insertion part (12) is encased at least partially with the insulating layer (19) or the insertion part (12) and the positioning element (14) is inserted into the mould (31) in particular for adjustment of the local spring constant of the metal matrix, and that the at least one positioning element (14) is preferably positioned directly on the face (21) of the insertion part (12) to abut flat thereon and is held in the mould (31), and that in particular the connection elements (36) are connected separately from the at least one positioning element (14) on the insertion part (12) in an electrically conductive manner.

7. Process according to claim 1, **characterised in that** the at least one positioning element (14) is configured by the insulating layer (19) at least partially encasing the insertion part (12) preferably by an accumulation of material (38) of the insulating layer (19), by means of which the insertion part (12) is placed in the correct position in the mould (31), and in particular the connection elements (36) are connected electrically with the insertion part (12) before the at least partial encasing with insulating layer (19) and preferably the accumulation of material (38) is provided to form the at least one positioning element (14) at least in the region of the connection elements (36), which leads the connection elements (36) through the metal matrix (24).

8. Process according to one of the preceding claims, **characterised in that** the insulating layer (19) is made from polymers, in particular PEEK, PAI, PI, LCP, PSU, from dental plastics, silicon, metal oxides, enamel, glass, ceramic, fibres or composites of the aforementioned materials.

9. Process according to one of the preceding claims, **characterised in that** a further layer is applied to the insertion part (12) or the insulating layer (19), which is thermally stable at least temporarily for the duration of the casting process.

10. Process according to one of the preceding claims, **characterised in that** the insertion part (12) is embedded with a metal melt using melt metallurgy, powder metallurgy, in particular by means of a casting process or die casting process.

11. Process according to one of the preceding claims, **characterised in that** a prestress is applied to the insertion part (12) by the metal matrix and a prestress acting on the insertion part (12) is preferably adjusted by holding the pressure during the casting process.

12. Process according to one of the preceding claims, **characterised in that** during the insertion of the metal matrix (24) the connection sections (22) of the positioning elements (14) or support elements (16) are electrically short-circuited.

13. Component with an integrated insertion part (12), in particular a function ceramic, which is produced in particular using a process according to claims 1 to 12,
• with a metal matrix (24), in which the insertion part (12) is embedded, **characterised in that**
• at least one positioning element (14) connecting to the insertion part (12) and configured as a further functional element (29, 36, 38) is provided, and
• that during insertion of the metal matrix (24) into the mould (31) the insertion part (12) is secured in the correct position in the mould (31) by the at least one positioning element (14), which after the insertion part (12) is embedded in the metal matrix (24) is positioned in an outer peripheral face of the metal matrix (24) or is directed out of the metal matrix (24).

14. Component according to claim 13, **characterised in that** the positioning element (14) is configured as an electrically conductive connection element (36), which is preferably configured by a support element (16) with at least one torsionally rigid body axis.

15. Component according to claim 13, **characterised in that** the support element (16), which is preferably configured in a strip shape or T shape, is connected at at least one end section to the insertion part (12) and has a free end as connection section (22) located opposite thereto.

16. Component according to claim 13, **characterised in that** the positioning element (14) is configured as a connecting element (29) and has at least one fastening section (26), and that the positioning element (14) is preferably configured as an accumulation of material (38) of the insulating layer (19) and adjoins the metal matrix (24) or is arranged opposite this to project therefrom, and preferably encloses an electrical connection element (36).

17. Component according to one of claims 13 to 16, **characterised in that** the insertion part (12) is coupled to a sensor, in particular a temperature sensor, or that the insertion part (12) is configured as an actuator, sensor, data transfer device or wireless energy transmission device.

## Revendications

1. Procédé d'obtention d'un composant (11) équipé d'une pièce d'insertion (12) intégrée en particulier d'une céramique fonctionnelle qui comporte au moins un élément de connexion électrique (36),
- selon lequel la pièce d'insertion (12) est enrobée dans une matrice métallique (24),
**caractérisé en ce que**
- au moins avant l'inclusion de la pièce d'insertion (12) dans la matrice métallique (24), au moins un élément de positionnement (14) est fixé sur la pièce d'insertion (12),
- pendant l'inclusion dans la matrice métallique (24), la pièce d'insertion (12) est maintenue par l'élément de positionnement (14) dans une position fixe par rapport au moule (31), et
- l'élément de positionnement (14) est réalisé sous la forme d'un autre élément fonctionnel (29, 36, 38) de la pièce d'insertion (12).

2. Procédé conforme à la revendication 1,
**caractérisé en ce que**
l'élément de positionnement (14) est réalisé sous la forme d'un élément de connexion (36) en un matériau électriquement conducteur, et l'élément de positionnement (14) est mis en contact électriquement conducteur directement avec la pièce d'insertion (12) de préférence avant l'enrobage au moins partiel de la pièce d'insertion (12), par une couche isolante (19).

3. Procédé conforme à la revendication 1 ou 2,
**caractérisé en ce que**
l'élément de positionnement (14) est relié par une liaison conductrice de l'électricité à la pièce d'insertion (12) par un agent adhésif électriquement conducteur, par un agent adhésif non électriquement conducteur avec interposition d'un contact électrique, par une liaison par bracage par une structure métallique par une liaison par la forme ou par la matière.

4. Procédé conforme à l'une des revendications précédentes,
**caractérisé en ce que**
la pièce d'insertion (12) est enrobée au moins partiellement, avec l'élément de positionnement (14) positionné sur celle-ci par une couche isolante (19), les faces frontales (21) de la pièce d'insertion (12) et les segments de connexion (22) de l'élément de positionnement (14) n'étant de préférence pas enrobés.

5. Procédé conforme à l'une des revendications précédentes,
**caractérisé en ce que**
sur le segment de connexion libre (22) de l'élément de positionnement (14) est monté un élément de positionnement auxiliaire (32) du moule (31) avant que la pièce d'insertion (12) soit positionnée dans le moule (31), ou le segment de connexion libre (22) de l'élément de positionnement (14) est monté directement dans le moule (31).

6. Procédé conforme à la revendication 1,
**caractérisé en ce que**
l'élément de positionnement (14) est réalisé sous la forme d'un élément de liaison (29) et est positionné sur au moins une face frontale (21) de la pièce d'insertion (12) avant que cette pièce d'insertion (12) soit enrobée au moins partiellement par la couche isolante (19), ou la pièce d'insertion (12) et l'élément de positionnement (14) sont insérés dans le moule (31) en particulier pour régler la constante de rappel locale de la matrice métallique, et, de préférence, l'élément de positionnement (14) est appliqué directement sur la surface frontale (21) de la pièce d'insertion (12) pour permettre un positionnement plan et est maintenu dans le moule (31), et, en particulier les éléments de connexion (36) sont mis en contact électriquement conducteur sur la pièce d'insertion (12) en étant séparés de l'élément de positionnement (14).

7. Procédé conforme à la revendication 1,
**caractérisé en ce que**
l'élément de positionnement (14) est réalisé par la couche isolante (19) enrobant au moins partiellement la pièce d'insertion (12), de préférence par une accumulation de matière (38) de la couche isolante (19) par laquelle la pièce d'insertion (12) est positionnée correctement dans le moule (31), et, en particulier les éléments de connexion (36) sont mis en contact électrique avec la pièce d'insertion (12) avant l'enrobage au moins partiel avec la couche isolante (19), et, de préférence, l'accumulation de matière (38) permettant de former l'élément de positionnement (14) est prévu au moins dans la zone des éléments de connexion (36) dans laquelle ces éléments sortent de la matrice métallique (24).

8. Procédé conforme à l'une des revendications précédentes,
**caractérisé en ce que**
la couche isolante (19) est réalisée en matériau polymère, en particulier en PEEK, PAI, PI, LCP, PSU, en matériaux synthétiques dentaires, en silicone, en oxydes métalliques, en émail, en verre, en céramique, en fibres, ou en des composés de ces matériaux.

9. Procédé conforme à l'une des revendications précédentes,
**caractérisé en ce qu'**
une autre couche est appliquée sur la pièce d'insertion (12) ou la couche isolante (19), cette autre couche étant résistante à la température au moins momentanément pendant la durée du procédé de coulée.

10. Procédé conforme à l'une des revendications précédentes,
**caractérisé en ce que**
la pièce d'insertion (12) est enrobée avec un métal fondu par un procédé de métallurgie par fusion ou de métallurgie des poudres en particulier par un procédé de coulée ou un procédé de coulée sous pression.

11. Procédé conforme à l'une des revendications précédentes,
**caractérisé en ce qu'**
une précontrainte est appliquée sur la pièce d'insertion par la matrice métallique, et de préférence, une précontrainte agissant sur la pièce d'insertion (12) est réglée par maintien en pression pendant le procédé de coulée.

12. Procédé conforme à l'une des revendications précédentes,
**caractérisé en ce que**
pendant l'introduction de la matrice métallique (24) les segments de connexion (22) des éléments de positionnement (14) ou des éléments support (16) sont mis en court-circuit électrique.

13. Composant équipé d'une pièce d'insertion intégrée (12) en particulier d'une céramique fonctionnelle en particulier obtenue conformément à la mise en oeuvre du procédé conforme aux revendications 1 à 12,
- comprenant une matrice métallique (24) dans laquelle est enrobée la pièce d'insertion (12),
**caractérisé en ce qu'**
- il est prévu au moins un élément de positionnement (14) relié à la pièce d'insertion (12) qui est réalisé sous la forme d'un autre élément fonctionnel (29, 36, 38), et
- pendant l'introduction de la matrice métallique (24) dans le moule (31), la pièce d'insertion (12) est fixée dans ce moule (31) dans une position correcte par l'élément de positionnement (14), qui, après l'enrobage de la pièce d'insertion (12) dans la matrice métallique (24) est positionné à la surface périphérique externe de la matrice métallique (24), ou sort de cette matrice métallique (24).

14. Composant conforme à la revendication 13,
**caractérisé en ce que**
l'élément de positionnement (14) est réalisé sous la forme d'un élément de connexion électriquement conducteur (36) qui est de préférence formée par un élément support (16) ayant au moins un axe de corps rigide à la torsion.

15. Composant conforme à la revendication 13,
**caractérisé en ce que**
l'élément support (16) qui est de préférence réalisé en forme de bande ou de T est relié à la pièce d'insertion (12) par au moins un segment d'extrémité et comporte en regard une extrémité libre constituant un segment de connexion (22).

16. Composant conforme à la revendication 13,
**caractérisé en ce que**
l'élément de positionnement (14) est réalisé sous la forme d'un élément de liaison (29) et comporte au moins un segment de fixation (26), et, de préférence, l'élément de positionnement (14) est réalisé sous la forme d'une accumulation de matière (38) de la couche isolante (19) est limitrophe de la matrice métallique (24) ou est situé en saillie par rapport à celle-ci, et, entoure de préférence un élément de connexion électrique (36).

17. Composant conforme à l'une des revendications 13 à 16,
**caractérisé en ce que**
la pièce d'insertion (12) est accouplée à un capteur, en particulier à un capteur de température, ou la pièce d'insertion (12) est réalisée sous la forme d'un actionneur, d'un capteur, d'un dispositif de transmission de données ou d'un dispositif de transmission d'énergie sans fil.
